# EUROPÄISCHE PATENTSCHRIFT

(11) **EP 0 419 996 B1**
(45) Veröffentlichungstag und Bekanntmachung des Hinweises auf die Patenterteilung: **05.04.1995**
(21) Anmeldenummer: 90117874.9
(22) Anmeldetag: 17.09.1990
(51) Int. Cl.: B23K 3/047, H05K 13/04

(54) **Lötvorrichtung zum Auflöten von Bauelementen auf Leiterplatten**
Soldering device for soldering components onto printed circuit boards
Dispositif de soudage pour souder des composants sur des plaquettes à circuits imprimés

(30) Priorität: 29.09.1989 DE 3932612
(43) Veröffentlichungstag der Anmeldung: 03.04.1991
(73) Patentinhaber: Siemens Nixdorf Informationssysteme Aktiengesellschaft, 33102 Paderborn (DE)
(72) Erfinder: Raschke, Josef, D-8011 Gelting (DE)
(74) Vertreter: Fuchs, Franz-Josef, Dr.-Ing.

(56) Entgegenhaltungen:
- EP-A- 0 121 910
- GB-A- 2 162 904
- GB-A- 2 167 038
- ELECTRONIC PACKAGING AND PRODUCTION. vol. 28, no. 2, Februar 1988, NEWTON,MASSACHUSETT, USA Seite 14 "Soldering machines take on quad flat packs"

## Beschreibung

Die Erfindung betrifft eine Lötvorrichtung zum Auflöten von Bauelementen auf Leiterplatten, mit mindestens zwei durch elektrische Widerstandswärme erhitzbaren Bügelelektroden und mit einer mittig zwischen den Bügelelektroden angeordneten Saugpipette zum Aufnehmen, Transportieren und Aufsetzen der Bauelemente auf die zugeordneten Lötstellen.

Lötvorrichtungen mit zwei parallel einander gegenüberliegenden Bügelelektroden oder mit vier paarweise einander gegenüberliegenden Bügelelektroden werden insbesondere für das Auflöten hochpoliger elektronischer Bauelemente wie Mikropacks, Flatpacks und dergleichen eingesetzt, wobei die Widerstandserwärmung der Bügelelektroden in der Regel durch Stromimpulse vorgenommen wird. Dabei sollte sowohl vor dem Lötvorgang als auch während der gesamten Dauer des Lötvorganges ein möglichst sicherer Kontakt zwischen den Arbeitsflächen der Bügelelektroden, den Anschlußbeinchen der Bauelemente und den Leiterbahnen, bzw. Anschlußpads der Leiterplatten gewährleistet sein.

Für die automatische Bestückung von Leiterplatten mit oberflächenlötbaren Bauelementen werden Bestückautomaten eingesetzt, die nach dem sogenannten Pick & Place-Prinzip arbeiten. Dabei bewegt sich über den Zuführmodulen der Bauelemente und der im Bestückbereich angeordneten Leiterplatte ein Bestückkopf, welcher mit einer Saugpipette die Bauelemente aus den Zuführmodulen aufnimmt, ggfs. zentriert und in die richtige Einbaulage dreht und in der vorgesehenen Bestückposition auf der Leiterplatte absetzt. Wird für das anschließende Auflöten der Bauelemente ein kombinierter Bestück- und Lötkopf verwendet, so kann die Saugpipette sowohl vor dem Lötvorgang als auch während der gesamten Dauer des Lötvorganges zusätzlich dazu herangezogen werden, das Bauelement mit einer begrenzten Kraft gegen die Lötstelle auf der Leiterplatte zu drücken. Bei einer Schieflage des Bauelements auf der Leiterplatte würde das Andrücken über die Saugpipette jedoch zu einer unerwünschten einseitigen Belastung des Bauelements und insbesondere der die Lötstelle zuerst berührenden Anschlußbeinchen führen. Eine derartige Schieflage kann sich beispielsweise durch einen Winkelversatz der Leiterplatten, durch Verwölbungen der Leiterplatten, durch unterschiedliche Höhen der Anschlußpads auf den Leiterplatten oder durch unterschiedlich gebogene Anschlußbeinchen der Bauelemente ergeben.

Aus ELECTRONIC PACKAGING AND PRODUCTION Vol. 28, Nr. 2, Februar 1988, Newton, Mass., USA, Seite 14 "Soldering machines take on quad flat pack" ist eine Lötvorrichtung der eingangs genannten Art bekannt. Mit der Saugpipette und den Bügeldektroden werden dabei während des Lötvorganges unabhängig voneinander Kräfte auf das Bauelement ausgeübt. Die Saugpipette hält das Bauelement mit einer Kraft von 1,1 bis 1,7 N an Ort und Stelle, während die Bügeldektroden mit einer Kraft von 2,8 N verbogene Anschlußbeinchen des Bauelements geradebiegen.

Aus der GB-A-2 167 038 ist es bekannt, Bauelemente mit einer Saugpipette aufzunehmen und dann über die Saugpipette mit einer vorgegebenen Kraft fest in den auf eine Leiterplatte aufgebrachten Klebstoff zu drücken. Um eine Beschädigung der Bauelemente durch den für die Klebung erforderlichen relativ hohen Druck zu verhindern, ist die Saugpipette mit einer elastischen Spitze versehen.

Aus der EP-A-0 121 910 und der GB-A-2 162 904 sind mit Saugpipetten ausgerüstete Entlötgeräte bekannt. Mit diesen Entlötgeräten werden die Anschlüsse elektronischer Bauelemente derart erwärmt, daß das die Anschlüsse mit einer Trägerplatte verbindende Lot schmilzt und die Bauelemente mit Hilfe der Saugpipetten entfernt werden können. Die Enden der Saugpipetten tragen Saugnäpfe, die durch ihre elastische Ausbildung und ihre glockenförmige Vergrößerung eine hohe Abhebekraft ermöglichen.

Der Erfindung liegt die Aufgabe zugrunde, eine Lötvorrichtung der eingangs genannten Art zu schaffen, bei welcher die für das Aufnehmen, Transportieren und Aufsetzen der Bauelemente verwendete Saugpipette auch bei einer Schieflage der Bauelemente auf der Leiterplatte zum Andrücken der Bauelemente auf die Lötstelle verwendet werden kann.

Diese Aufgabe wird erfindungsgemäß dadurch gelöst, daß die Saugpipette zumindest in ihrem dem Bauelement zugewandten Öffnungsbereich aus einem elastisch verformbaren Material besteht. Dieses elastisch verformbare Material ermöglicht dann in ähnlicher Weise wie ein sphärisches Lager eine Anpassung der Saugpipette an eine Schieflage des Bauelements, wobei diese Anpassung auch zu einem gewissen Ausgleich des auf die Anschlußbeinchen ausgeübten Druckes führt. Wird dann beim Lötvorgang durch den über die Bügelelektroden ausgeübten Druck bzw. durch das Aufschmelzen der Anschlußpads die ursprüngliche Schieflage des Bauelementes beseitigt, so kann das elastisch verformbare Material der Saugpipette in diesem Fall sich der neuen Lage des Bauelements anpassen.

Gemäß einer bevorzugten Ausgestaltung der Erfindung bildet das elastisch verformbare Material in dem dem Bauelement zugewandten Öffnungsbereich der Saugpipette eine ringförmig umlaufende Lippe. Mit einer derartigen Lippe kann einerseits die Anpassung an eine eventuelle Schieflage eines Bauelements noch weiter verbessert werden und andererseits aber auch durch die Wahl des Materials und durch die Wahl der Abmessungen der Lippe eine optimale Anpassung an die Beschaffenheit der Bauelemente vorgenommen werden.

Weiterhin hat es sich als vorteilhaft erwiesen, wenn die starre Hülse der Saugpipette einen Pipetten-Einsatz aus dem elastisch verformbaren Material trägt. Mit einem derartigen Pipetten-Einsatz kann die elastische Anpassung noch besser an die Wirkung eines entsprechenden sphärischen Lagers angenähert werden.

Als elastisch verformbares Material ist vorzugsweise Hartgummi oder Kunststoff vorgesehen. Die Wahl des Materials ist jedoch immer auf die Beschaffenheit der jeweiligen Bauelemente abzustimmen.

Ein Ausführungsbeispiel der Erfindung ist in der Zeichnung dargestellt und wird im folgenden näher beschrieben.

Es zeigen
Fig. 1 eine Lötvorrichtung mit elastischer Anpassung der Saugpipette an die Schieflage eines nachfolgend zu verlötenden Elements,
Fig. 2 die Lötvorrichtung gemäß Fig. 1 nach dem Lötvorgang und
Fig. 3 einen halbseitigen Längsschnitt durch die Saugpipette der in den Fig. 1 und 2 dargestellten Lötvorrichtung.

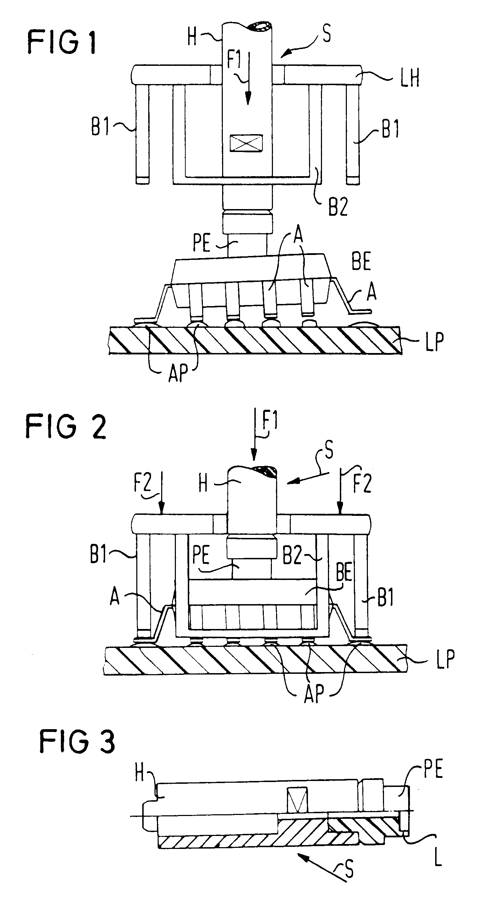

Fig. 1 zeigt in stark vereinfachter schematischer Darstellung das Grundprinzip einer erfindungsgemäßen Lötvorrichtung, wobei die zum Verständnis der Erfindung nicht erforderlichen Teile wie Stromzuführungen und dergleichen weggelassen wurden. Die dargestellte Lötvorrichtung besitzt vier an einem Lötbügelhalter LH befestigte U-förmige Bügelelektroden, wobei jeweils zwei Bügelelektroden B1 und zwei Bügelelektroden B2 derart im Abstand zueinander parallel ausgerichtet sind, daß die Arbeitsflächen auf der Unterseite der Bügelelektroden B1 und B2 einen in den Endbereichen nicht geschlossenen rechteckförmigen oder quadratischen Rahmen bilden. Die Abmessungen dieses Rahmens sind dabei auf die Form und Lage der Anschlußbeinchen A eines auf die Anschlußpads AP einer Leiterplatte LP aufzulötenden Bauelements BE abgestimmt.

Die Bauelemente BE werden mit der Saugpipette S eines in der Zeichnung nicht näher dargestellten Bestückkopfes aus einem Magazin oder aus einem Zuführmodul entnommen und auf die vorgegebene Lötstelle auf der Leiterplatte Lp abgesetzt. Aufbau und Wirkungsweise eines mit einer Saugpipette ausgerüsteten Bestückkopfes gehen beispielsweise aus der US-A-4 135 630 hervor.

Beim Aufsetzen des Bauelements BE auf die vorgegebene Lötstelle auf der Leiterplatte LP sollen die zweifach abgebogenen Anschlußbeinchen A mit den Anschlußpads AP in Kontakt kommen. Aufgrund eines Winkelversatzes der Leiterplatte Lp, durch Verwölbungen der Leiterplatte Lp, durch unterschiedliche Höhen der Anschlußpads AP, durch unterschiedlich gebogene Anschlußbeinchen A oder durch ähnliche Ursachen kann es jedoch zu einer in Fig. 1 übertrieben dargestellten Schieflage des Bauelementes BE relativ zur Leiterplatte LP kommen. Wird nun bei einer derartigen Schieflage die Saugpipette S dazu benutzt, das Bauelement BE vor dem Lötvorgang und während der gesamten Dauer des Lötvorganges mit einer begrenzten Kraft F1 von beispielsweise 0,1 N bis 0,5 N gegen die Leiterplatte LP zu drücken, so würde es bei einer vollständig starren Ausbildung der Saugpipette S zu einer unerwünschten einseitigen Belastung des Bauelements BE und der vorzeitig auf den zugeordneten Anschlußpads AP aufsitzenden Anschlußbeinchen A kommen. Zur Lösung dieses Problems ist - wie es insbesondere auch aus Fig. 3 ersichtlich ist - im unteren Ende der starren, metallischen Hülse H der Saugpipette S ein Pipetten-Einsatz PE aus einem elastisch verformbaren Material wie z.B. Hartgummi, Silikonkautschuk oder dergleichen aufgenommen. Wie es aus Fig. 1 ersichtlich ist, passt sich dieser Pipetten-Einsatz PE in ähnlicher Weise wie ein sphärisches Lager an die Schieflage des Bauelements BE an und bewirkt damit auch einen gewissen Ausgleich der einseitigen Belastung von Bauelement BE und Anschlußbeinchen A. Dieser elastische Ausgleich wird zusätzlich noch durch die in Fig. 3 erkennbare ringförmig umlaufende Lippe L verstärkt.

Gemäß Fig. 2 wird nach dem Positionieren des Bauelements BE auf der vorgegebenen Lötstelle der Leiterplatte LP der Lötbügelhalter LH nach unten gefahren, wobei die Arbeitsflächen der Bügelelektroden B1 und B2 die Anschlußbeinchen A mit einer Kraft F2 von beispielsweise 40 N gegen die zugeordneten Anschlußpads AP drücken. Gleichzeitig wird auch die über die Saugpipette S auf das Bauelement BE ausgeübte Kraft F1 aufrechterhalten. Das Aufschmelzen des Lotes der Anschlußpads AP erfolgt dann durch eine entsprechende elektrische Widerstandserwärmung der Bügelelektroden B1 und B2, wobei spätestens nach diesem Aufschmelzen die ursprüngliche Schieflage des Bauelements BE vollständig beseitigt wird. Es ist erkennbar, daß der Pipetten-Einsatz PE sich auch dieser neuen, nunmehr richtigen Lage des Bauelements BE anpasst.

Nach dem Aufschmelzen des Lotes der Anschlußpads AP können zur Bildung einer definierten Lotschicht zwischen Anschlußbeinchen A und zugeordneten Anschlußpads AP der Lötbügelhalter LH angehoben und das Bauelement BE durch Hochfahren der Saugpipette S um einen definierten Weg von beispielsweise 10 Mikrometern nach oben zurückgezogen werden.

Bei der vorstehend beschriebenen Lötvorrichtung kann durch eine gelenkige Aufhängung des Lötbügelhalters LH mit einem mittig in der Ebene zwischen den Arbeitsflächen der Bügelelektroden B1 und B2 liegenden Dreh- und Ausgleichszentrum vor dem Lötvorgang und während der gesamten Dauer des Lötvorganges ein stets sicherer Kontakt zwischen den Arbeitsflächen, dem Anschlußbeinchen A und dem Anschlußpads AP gewährleistet werden. Eine derartige gelenkige Aufhängung eines Lötbügelhalters ist beispielsweise in der älteren Patentanmeldung P 39 005 20.8 dargestellt und beschrieben.

## Patentansprüche

1. Lötvorrichtung zum Auflöten von Bauelementen (BE) auf Leiterplatten (LP), mit mindestens zwei durch elektrische Widerstandswärme erhitzbaren Bügelelektroden (B1,B2) und mit einer mittig zwischen den Bügelelektroden (B1,B2) angeordneten Saugpipette (S) zum Aufnehmen, Transportieren und Aufsetzen der Bauelemente (BE) auf die zugeordneten Lötstellen,
**dadurch gekennzeichnet,**
daß die Saugpipette (S) zumindest in ihrem dem Bauelement (BE) zugewandten Öffnungsbereich aus einem elastisch verformbaren Material besteht.

2. Lötvorrichtung nach Anspruch 1,
**dadurch gekennzeichnet,**
daß das elastisch verformbare Material in dem dem Bauelement (BE) zugewandten Öffnungsbereich der Saugpipette (S) eine ringförmig umlaufende Lippe (L) bildet.

3. Lötvorrichtung nach Anspruch 1 oder 2,
**dadurch gekennzeichnet,**
daß die starre Hülse (H) der Saugpipette (S) einen Pipetten-Einsatz (PE) aus dem elastisch verformbaren Material trägt.

4. Lötvorrichtung nach einem der vorhergehenden Ansprüche,
**dadurch gekennzeichnet,**
daß als elastisch verformbares Material Hartgummi oder Kunststoff vorgesehen ist.

## Claims

1. Soldering device for soldering components (BE) onto printed circuit boards (LP), having at least two soldering-iron electrodes (B1, B2), which can be heated by electrical resistance heat, and a suction pipette (S) arranged centrally between the soldering-iron electrodes (B1, B2) for picking up, transporting and setting down the components (BE) onto the associated soldering points, characterized in that the suction pipette (S) comprises, at least in its opening region facing the component (BE), an elastically deformable material.

2. Soldering device according to Claim 1, characterized in that the elastically deformable material in the opening region, facing the component (BE), of the suction pipette (S) forms an annular circumferential lip (L).

3. Soldering device according to Claim 1 or 2, characterized in that the rigid sleeve (H) of the suction pipette (S) carries a pipette insert (PE) made from the elastically deformable material.

4. Soldering device according to one of the preceding claims, characterized in that hard rubber or plastic is provided as elastically deformable material.

## Revendications

1. Dispositif de brasage pour fixer par brasage des composants (BE) sur de plaquettes à circuits imprimés (LP), comportant au moins deux électrodes en forme d'étriers (B1,B2) pouvant être chauffées par de la chaleur produite par effet Joule et comportant une pipette d'aspiration (S) disposée en position centrée entre les électrodes en forme d'étriers (B1,B2) et servant à recevoir, transporter et déposer les composants (SE) sur les zones de brasage associées, caractérisé par le fait que la pipette d'aspiration (S) est constituée, au moins dans la zone de son ouverture tournée vers le composant (BE), en un matériau élastiquement déformable.

2. Dispositif de brasage suivant la revendication 1, caractérisé par le fait que le matériau élastiquement déformable forme, dans la zone d'ouverture de la pipette d'aspiration (S) tournée vers le composant (BE), une lèvre périphérique annulaire (L).

3. Dispositif de brasage suivant la revendication 1 ou 2, caractérisé par le fait que la douille rigide (H) de la pipette d'aspiration (S) porte une pièce rapportée (PE) en un matériau élastiquement déformable.

4. Dispositif de brasage suivant l'une des revendications précédentes, caractérisé par le fait qu'il est prévu, comme matériau élastiquement déformable, un caoutchouc dur ou une matière plastique.
